# FASCICULE DE BREVET EUROPEEN

(11) **EP 0 547 960 B1**
(45) Date de publication et mention de la délivrance du brevet: **09.07.1997**
(21) Numéro de dépôt: 92403417.6
(22) Date de dépôt: 15.12.1992
(51) Int. Cl.: H04L 25/30, G01R 19/25

(54) **Méthode et dispositif pour mesurer les niveaux d'amplitude successifs de signaux reçus sur une voie de transmission**
Verfahren und Vorrichtung zur Messung aufeinanderfolgender Amplitudenwerte von Signalen, die über eine Übertragungsstrecke empfangen werden
Method and apparatus for measuring successive amplitude levels of signals received over a communication path

(30) Priorité: 19.12.1991 FR 9115974
(43) Date de publication de la demande: 23.06.1993
(73) Titulaire: INSTITUT FRANCAIS DU PETROLE, 92506 Rueil-Malmaison Cédex (FR)
(72) Inventeur: Coquerel, Patrick, F-78500 Sartrouville (FR)

(56) Documents cités:
- EP-A- 0 262 038
- EP-A- 0 316 876
- EP-A- 0 412 234
- EP-A- 0 514 629
- PATENT ABSTRACTS OF JAPAN vol. 7, no. 107 (E-174)(1252) 11 Mai 1983 & JP-A-58 029 226
- IEEE 1986 REGION 5 CONFERENCE PROCEEDINGS, 8-11 AVRIL 1986, NEW YORK, US, R. R. HENRY: 'AN IMPROVED RECEIVER SYSTEM FOR ASYNCHRONOUS COMMUNICATION SYSTEMS', PAGES 129-134

## Description

L'invention a pour objet une méthode et un dispositif pour mesurer avec précision les niveaux d'amplitude successifs de signaux reçus sur une voie de transmission..

La méthode selon l'invention peut trouver des applications dans de nombreux cas où l'on reçoit des signaux d'amplitude variable. Elle peut notamment s'appliquer dans le domaine des transmissions de signaux modulés en amplitude. Elle va être décrite ci-après, appliquée à un type de transmission où les signaux à mesurer sont rythmés par un signal d'horloge et dont l'amplitude est soumise à des variations notamment en raison du mode de codage qui a été choisi pour leur transmission sur la voie de transmission.

La mesure précise des niveaux successifs pris par un signal reçu par un dispositif de réception peut être faite par exemple suivant une technique connue en soi, en prélevant sur lui à intervalles discrets, plusieurs échantillons successifs et en calculant une moyenne de leurs mesures respectives. Ces groupes d'échantillons peuvent être prélevés par exemple à chaque période du signal reçu. Les résultats sont valides à condition d'avoir correctement positionné l'intervalle de temps ou fenêtre pendant laquelle les échantillons d'un même groupe sont prélevés, sur une fraction déterminée du signal, une demi-période par exemple. Le positionnement précis de la fenêtre d'échantillonnage par rapport au signal, peut être réalisé avec précision si l'on dispose d'une horloge locale bien synchrone avec le signal d'horloge véhiculé avec le signal reçu.

Cette technique de mesure de niveau à partir d'un groupe d'échantillons successifs, fournit des résultats précis si les conditions de transmission sont satisfaisantes. Si les signaux transmis sont déformés par leur propagation sur une voie de transmission dont la bande passante est insuffisante pour le débit de données à transmettre ou si le bruit de fond superposé au signal reçu est relativement important, les mesures de niveau peuvent être entachées d'erreur. Dans le cas d'une transmission du type multi-niveaux appliquée à la transmission de données numérisées où l'écart entre deux niveaux successifs peut être relativement faible, une erreur sur la mesure des niveaux peut entraîner une confusion sur les symboles logiques reçus. Les signaux analogiques restitués après décodage s'en trouvent faussés.

Par la demande de brevet EP-A- 262.038, on connait un système de correction d'un signal reçu sur une voie de transmission et arrivant plus ou moins déformé. qui reconstitue par le calcul un signal original dont on connait la loi de variation (sinusoïdale par exemple). Au moyen d'un "peigne" d'échantillonnage, un certain nombre d'échantillons sont successivement prélevés sur le signal reçu, numérisés et transférés dans un dispositif de calcul adapté à reconstituer le signal tel qu'il a été envoyé sur la voie.

La méthode selon l'invention permet de mesurer avec précision les niveaux d'amplitude successifs d'un signal périodique d'amplitude variable, reçu sur une voie de transmission. Elle comporte
- la reconstitution d'un signal d'horloge synchrone avec ledit signal périodique;
- l'échantillonnage du signal périodique au moins pendant des intervalles de temps d'échantillonnage égaux chacun à une fraction définie de sa période et à une fréquence d'échantillonnage suffisante pour obtenir des groupes successifs contenant chacun un nombre défini d'échantillons distincts durant ledit intervalle de temps; et - la numérisation sur un certain nombre n de bits de chacun des échantillons (E1...Em) contenu dans chaque groupe.

La méthode est caractérisée en ce qu'elle comporte :
- la comparaison de chaque groupe d'échantillons numérisés avec une liste modèle préétablie de groupes d'échantillons admissibles pourvus de pondérations appropriées et, selon le résultat de chaque comparaison;
- l'affectation à chaque groupe d'échantillons numérisés, d'une valeur numérisée unique pondérée associée au groupe de la liste modèle correspondant et représentative du niveau effectif du signal périodique durant l'intervalle de temps d'échantillonnage, la pondération appliquée tenant compte de la fraction du signal qui est échantillonnée et, des conditions de propagation sur la voie de transmission.

Cette affectation est effectuée par exemple en allant lire directement un mot numérisé unique représentatif du niveau du signal durant l'intervalle de temps d'échantillonnage si la configuration du groupe d'échantillons numérisés correspond à un mot numérisé de ladite liste modèle préétablie de mots numérisés, ce mot étant localisé à un emplacement d'une mémoire, à une adresse fixée par le groupe d'échantillons numérisés obtenu à chaque échantillonnage.

Dans le cas où les signaux reçus sont des signaux numérisés codés dont la transmission est rythmée par un signal d'horloge, elle comporte le positionnement de l'intervalle de temps d'échantillonnage par une horloge locale synchronisée avec ce signal d'horloge.

Dans le cas où les signaux reçus sont des signaux modulés en amplitude, on positionne l'intervalle de temps d'échantillonnage par une horloge synchronisée avec la fréquence desdits signaux modulés.

Le dispositif selon l'invention comporte :
- des moyens pour reconstituer un signal d'horloge synchrone avec le signal périodique;
- des moyens d'échantillonnage du signal périodique au moins pendant des intervalles de temps d'échantillonnage égaux chacun à une fraction définie de sa période et à une fréquence d'échantillonnage suffisante pour obtenir des groupes successifs contenant chacun un nombre défini d'échantillons distincts durant ledit intervalle de temps; et
- des moyens de numérisation sur un certain nombre n de bits de chacun des échantillons contenu dans chaque groupe. Il est caractérisé en ce qu'il comporte :
- des moyens de comparaison de chaque groupe d'échantillons numérisés avec une liste modèle préétablie de groupes d'échantillons admissibles pourvus de pondérations appropriées et, selon le résultat de chaque comparaison,
- des moyens incluant une unité de mémorisation pour affecter à chaque groupe d'échantillons numérisés, une valeur numérisée unique pondérée associée au groupe correspondant de la liste modèle et représentative du niveau effectif du signal périodique durant l'intervalle de temps d'échantillonnage, la pondération appliquée tenant compte de la fraction du signal qui est échantillonnée et, des conditions de propagation sur la voie de transmission.

Les moyens de sélection comportent par exemple une mémoire adressable contenant des mots numériques représentatifs de valeurs d'amplitude, et et des moyens pour former des adresses de lecture de la mémoire à partir d'une partie au moins du contenu des moyens de mémorisation, qui. comportent par exemple des éléments de mémorisation pour l'ensemble des mots numériques prélevés durant chaque intervalle de temps d'échantillonnage.

Le dispositif peut comporter des moyens d'adaptation du niveau des signaux reçus sur ladite voie de transmission avant leur application aux moyens de numérisation.

Les moyens de restitution d'horloge comportent par exemple une horloge locale, des moyens de stockage connectés aux moyens de numérisation, pour des échantillons numérisés prélevés pendant des intervalles de temps incluant des instants de transition dudit signal entre des niveaux d'amplitude, des moyens pour déterminer les écarts relatifs de niveau les uns par rapport aux autres des échantillons prélevés durant chaque intervalle de temps et constituer avec chacun d'eux un ensemble de valeurs d'écart et un ensemble de commande pour générer des signaux de correction en fonction de l'ensemble de valeurs d'écart obtenu suite à la comparaison de chacun des ensembles avec une liste de configurations-types reconnues correctes, ces moyens de comparaison étant adaptés à produire des signaux de correction permettant de resynchroniser l'horloge locale avec le signal d'horloge.

Les moyens pour déterminer les écarts relatifs, peuvent comporter deux registres adaptés à contenir les mots numériques successifs, des moyens de comparaison deux à deux des mots numériques successifs contenus dans les deux registres, et des moyens de mémorisation pour contenir les ensembles d'écarts relatifs.

Les moyens de comparaison sont adaptés à comparer chaque écart relatif à un écart seuil.

Suivant un mode de réalisation, l'horloge locale comporte un oscillateur à haute fréquence, des premiers moyens diviseurs de fréquence pour diviser la fréquence du signal de l'oscillateur par plusieurs facteurs différents autour d'une valeur centrale, et sélectionner l'un des facteurs en fonction desdits signaux de correction reçus des moyens de sélection, et des deuxièmes moyens diviseurs connectés aux premiers moyens diviseurs pour engendrer un premier signal à la même fréquence que le signal d'horloge reçu et un signal de synchronisation à une fréquence multiple de celle du premier signal.

D'autres caractéristiques et avantages de la méthode et du dispositif selon l'invention apparaîtront mieux à la lecture de la description ci-après de modes de réalisation décrits à titre d'exemples non limitatifs, en se référant aux dessins annexés où :
- la Fig.1 montre un exemple de signaux codés à niveaux multiples reçus sur une voie de transmission et rythmés par un signal d'horloge, avec un intervalle de temps ou fenêtre d'échantillonnage positionné sur des portions de signal de niveau sensiblement constant;
- la Fig.2 montre le cas d'un intervalle de temps d'échantillonnage recouvrant une portion d'amplitude variable du signal reçu à mesurer;
- la Fig.3 est un schéma synoptique un premier mode de réalisation du dispositif selon l'invention appliqué par exemple à la mesure des amplitudes successives d'un signal codé tel que celui représenté à la Fig.1;
- la Fig. 3A montre schématiquement un ensemble de réception des signaux; et
- la Fig.4 est un schéma synoptique d'un deuxième mode de réalisation où la mesure du signal ainsi que la synchronisation d'une horloge locale nécessaire au positionnement d'une fenêtre d'échantillonnage, sont réalisés toutes les deux de façon analogue.

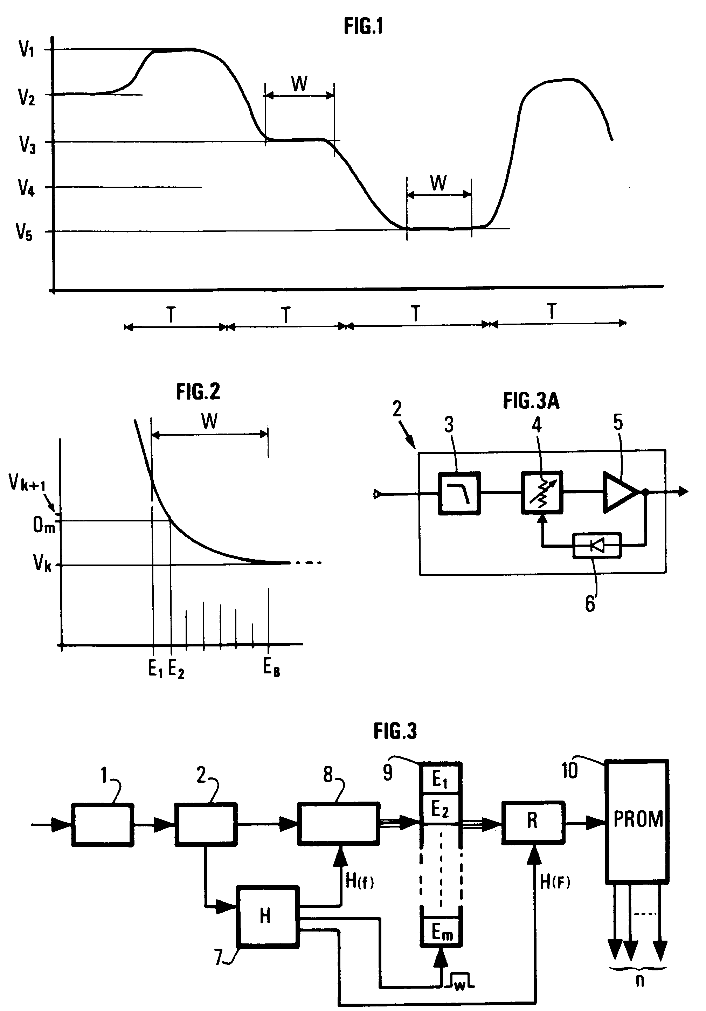

Un signal tel que celui montré à la Fig.1, est obtenu à partir d'un certain nombre de tensions électriques v1, v2, ... d'amplitude déterminées (huit ou seize par exemple). A chacun de ses paliers successifs, correspond une combinaison particulière de signaux binaires qui peuvent être transmis simultanément sur une voie de transmission, comme il est bien connu des spécialistes. Ainsi, la détermination précise du niveau de chacun des paliers successifs du signal reçu sur cette voie, permet de restituer les signaux binaires transmis. La mesure de chacun des niveaux est effectuée durant une fenêtre W qui doit être positionnée avec précision pour éviter toute erreur dans la reconnaissance du niveau.

La méthode selon l'invention comporte tout d'abord la formation de groupes de mots numériques représentatifs chacun d'un groupe d'échantillons prélevés successivement sur une portion déterminée du signal reçu. Cette formation de groupes de mots numériques nécessite au préalable un positionnement précis d'un intervalle de temps ou fenêtre de mesure par rapport à la portion du signal choisi, ce qui est réalisé par un calage d'un élément-horloge sur le signal d'horloge reçu avec les signaux.

La méthode selon l'invention comporte ensuite une étape de calcul de la moyenne pondérée (moyennage) des mots numériques de chaque groupe permettant une reconnaissance exacte des niveaux successivement mesurés. Il apparaît en effet qu'une combinaison simple des mots d'un même groupe peut conduire à des erreurs sur la détermination des niveaux réels. Quand les déformations subies par les signaux sur la voie de transmission sont importantes (cf. Fig. 2 par exemple), la fenêtre de mesure W peut coïncider avec une portion de palier présentant des variations d'amplitude importantes. Les échantillons numérisés formés dans cette fenêtre présentent entre eux des écarts notables. Les risques d'erreur sur le niveau moyen affecté à un tel groupe augmentent de façon importante. C'est d'autant plus fréquent que le nombre de niveaux distincts à reconnaître est important et les écarts entre les niveaux relativement faibles. Par cette opération de moyennage pondéré, il est possible facilement de tenir compte facilement des conditions réelles de transmission sur la voie utilisée : débit, niveau de bruit etc.

Cette opération de moyenne pondérée peut être réalisée en comparant chaque groupe d'échantillons numérisés avec une liste préétablie de mots numérisés pourvus de pondérations appropriées. En fonction du résultat de chaque comparaison, on affecte à chaque groupe d'échantillons numérisés une valeur numérisée unique représentative du niveau du signal périodique durant l'intervalle de temps d'échantillonnage la pondération appliquée tenant compte de la fraction du signal périodique échantillonné et des conditions de propagation sur la voie de transmission. On voit par exemple sur la Fig.2 qu'une moyenne simple faite sur les échantillons E1 à E8 prélevés dans une fenêtre W conduirait à une valeur moyenne am et à l'affectation aux échantillons du groupe d'un niveau Vk+1. Si l'on sait que compte-tenu de la bande passante de la voie de transmission et du débit de transmission requis, les signaux seront déformés, avec un traînage important, on décidera d'affecter au groupe d'échantillons le niveau Vk par exemple, qui est le niveau du palier atteint avec un certain retard par rapport à la transition.

Le dispositif selon l'invention reçoit des signaux codés rythmés par un signal d'horloge sur une voie de transmission 1 constituée par exemple d'une ligne de transmission. Il comporte tout d'abord (Fig.3), des moyens pour positionner avec précision un intervalle de temps ou fenêtre sur une fraction déterminée du signal, telle qu'une portion de chacun de ses paliers successifs par exemple. Ces moyens comportent un ensemble de réception 2 approprié aux signaux reçus, qui, dans le cas d'une ligne de transmission, comporte par exemple (Fig. 3A) un filtre passe-bas 3. L'affaiblissement des signaux issus du filtre 3 et dû à la transmission, est compensé par un ensemble de contrôle automatique de gain 4 comprenant un atténuateur variable 5, un amplificateur 6 et un détecteur d'enveloppe 7 connecté à la sortie de l'amplificateur 6, qui contrôle le facteur d'atténuation de l'atténuateur 5. Les signaux issus de l'ensemble de contrôle 4 sont appliqués à un ensemble de régulation d'horloge 7 d'un type connu adapté à produire un premier signal de référence H(f) de fréquence f synchrone avec le signal d'horloge rythmant les signaux reçus et un deuxième signal H(F) de fréquence F multiple de la précédente et des signaux définissant une fenêtre de temps W pendant lequel on va procéder à une sélection d'échantillons. Un tel ensemble de régulation d'horloge comporte une boucle de type PLL incluant un oscillateur local, telle que celle décrite par exemple dans le brevet FR 2 624 323 du demandeur.

Le signal issu de l'ensemble de réception 2 est aussi appliqué à un convertisseur analogique-numérique (C.A.N) 8 qui échantillonne le signal et numérise les échantillons successifs, à une cadence fixée par le signal H(F) issu de l'ensemble 7. Le convertisseur 8 produits des mots numériques à n bits (n= 4 ou 8 par exemple). Les mots numériques E1, E2, ... Em (m est par exemple égal à 8) produits durant la fenêtre W imposée par l'ensemble 7, sont chargés en série dans un registre 9. Les sorties en parallèle du registre 9 sont connectées respectivement aux entrées du registre d'adresse R d'une mémoire 10.

L'opération de comparaison est effectuée ici en allant lire directement à un emplacement d'une mémoire dont l'adresse est fixée à chaque échantillonnage, par le groupe d'échantillons numérisés obtenu, le mot numérisé unique que l'on est convenu d'affecter du niveau du signal dans la fenêtre de mesure. L'affectation de niveau est simple à réaliser en chargeant une mémoire du type PROM en fonction des conditions d'utilisation de la voie de transmission.

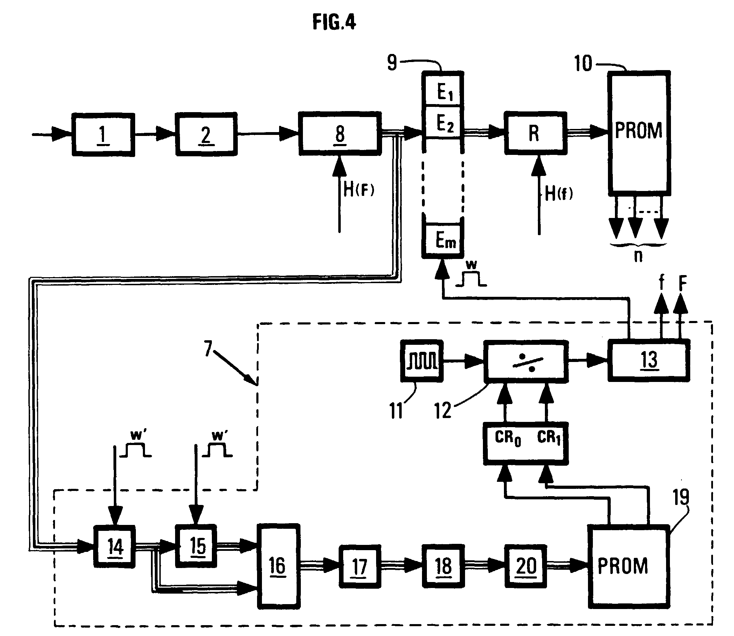

Suivant le mode de réalisation de la Fig.4, la synchronisation d'une horloge locale permettant le positionnement précis de la fenêtre W, est basé sur un principe analogue d'analyse de groupes d'échantillons et de comparaisons avec une liste prédéterminée dans une mémoire 10. Sur les schémas des Fig.3 et 4, les éléments portant les références 1 à 6 et 8 à 10 sont identiques. L'ensemble 7 de régulation d'horloge est ici connecté à la sortie du convertisseur 8 et il est analogue à celui décrit dans la demande de brevet EP-A-0 541 431.

L'ensemble 7 comporte une horloge locale constituée d'un oscillateur à haute fréquence 11, un ensemble de division 12 adapté à diviser la fréquence du signal de l'oscillateur 11 par un facteur 7, un facteur 8 ou 9 par exemple et à sélectionner l'un des trois signaux résultant en fonction de signaux de correction CR0 ou CR1, et des éléments diviseurs 13 recevant les signaux sélectionnés et après division, produisant les signaux d'horloge H(f), H(F), des signaux définissant la fenêtre W et des signaux définissant une autre fenêtre W' centrée sur les transitions successives des signaux reçus. La fréquence F est choisie par exemple égale à 8.f ou 16.f.

L'ensemble 7 comporte des moyens de comparaison d'échantillons numériques prélevés durant la fenêtre d'échantillonnage W' centrée sur les transitions du signal reçu. Ces moyens comportent un registre 14 connecté à la sortie du convertisseur 8, qui reçoit à la fréquence F les mots numériques issus de ce dernier. Le registre 14 est connecté en série avec un registre 15 de façon que les mots numériques passent successivement dans l'un et dans l'autre. Ces mots ou échantillons consécutifs sont comparés l'un à l'autre à la même fréquence par un moyen de compararaison 16 adapté d'une part à déterminer leur écart relatif et d'autre part à comparer cet écart relatif à un écart seuil. On lui donne la valeur 1 si l'écart relatif entre deux quelconques échantillons numérisés est suffisant, et 0 dans le cas contraire. Les valeurs binaires issues successivement du moyen de comparaison 16 sont transférées dans un registre à décalage 17. Les mots formés par toutes les valeurs binaires obtenus dans chaque fenêtre W'sont mémorisés dans un registre 18. Chacun de ces mots correspond à une configuration d'écarts représentative d'une transition qui a été échantillonnée. L'ensemble 7 comporte encore des moyens de comparaison pour reconnaître si cette configuration est acceptable. Ces moyens comportent une mémoire du type EPROM 19 dont le registre d'adresse 20 est connecté en parallèle au registre 18. Les mots numériques dans celui-ci adressent directement la mémoire 19 et permettent la lecture dans celle-ci de mots numériques à 2 bits CR0, CR1 mémorisés au préalable. Si la configuration de bits dans le registre 18 est acceptable c'est-à-dire si le synchronisme entre l'horloge détectée sur la voie de transmission et l'horloge locale est considéré comme correct, le mot numérique lu ne provoque aucune action corrective. D'autres correspondent à des cas où l'horloge locale est en avance sur le signal d'horloge transmis. D'autres configurations encore correspondent à des cas où l'horloge locale est en retard. Les signaux logiques CR0 et CR1 issus de la mémoire sont appliqués aux moyens de division 12.

Si le signal de l'horloge locale s'avère être en avance par rapport à l'horloge transmise, l'application du signal correcteur CR0 par exemple, entraîne la sélection du facteur de division 8 par l'ensemble de division 12, de manière à diminuer les fréquences f et F produites par les éléments diviseurs 11. Un retard de l'horloge locale au contraire a pour effet une sélection du facteur de division 7 par l'ensemble de division 12 et une augmentation des mêmes fréquences.

L'invention a été décrite appliquée à la mesure des niveaux sucessifs d'un signal codé rythmé par un signal d'horloge. On ne sortirait pas de l'invention toutefois en appliquant la méthode à la mesure périodique de l'enveloppe d'un signal modulé reçu sur une voie de transmission.

La voie de transmission sur laquelle les signaux codés sont reçus peut être une ligne de transmission. Elle peut aussi être constituée par un canal radio constituée d'une porteuse modulée avec une modulation d'un type connu convenant pour les signaux à transmettre.

## Revendications

1. Méthode pour mesurer avec précision les niveaux d'amplitude successifs d'un signal périodique d'amplitude variable, reçu sur une voie de transmission, comportant
- la reconstitution d'un signal d'horloge H(f) synchrone avec ledit signal périodique;
- l'échantillonnage du signal périodique au moins pendant des intervalles de temps d'échantillonnage (W) égaux chacun à une fraction définie de sa période et à une fréquence d'échantillonnage (F) suffisante pour obtenir des groupes successifs contenant chacun un nombre défini d'échantillons distincts durant ledit intervalle de temps; et
- la numérisation sur un certain nombre n de bits de chacun des échantillons (E1...Em) contenu dans chaque groupe, la méthode étant caractérisée en ce qu'elle comporte :
- la comparaison de chaque groupe d'échantillons numérisés avec une liste modèle préétablie de groupes d'échantillons admissibles pourvus de pondérations appropriées et, selon le résultat de chaque comparaison;
- l'affectation à chaque groupe d'échantillons numérisés, d'une valeur numérisée unique pondérée associée au groupe correspondant de la liste modèle et représentative du niveau effectif du signal périodique durant l'intervalle de temps d'échantillonnage, la pondération appliquée tenant compte de la fraction du signal qui est échantillonnée et, des conditions de propagation sur la voie de transmission.

2. Méthode selon la revendication 1, caractérisée en ce que ladite affectation est effectuée en allant lire directement un mot numérisé unique représentatif du niveau du signal durant l'intervalle de temps d'échantillonnage si la configuration du groupe d'échantillons numérisés correspond à un mot numérisé de ladite liste modèle préétablie de mots numérisés, lequel mot numérisé est localisé à un emplacement d'une mémoire, l'adresse dudit emplacement étant fixée par le groupe d'échantillons numérisés obtenu à chaque échantillonnage.

3. Méthode selon la revendication 1, caractérisée en ce que, les signaux reçus étant des signaux numérisés codés dont la transmission est rythmée par un signal d'horloge, elle comporte le positionnement de l'intervalle de temps d'échantillonnage par une horloge locale synchronisée avec ledit signal d'horloge.

4. Méthode selon la revendication 1, caractérisée en ce que les signaux reçus étant des signaux modulés en amplitude, elle comporte le positionnement de l'intervalle de temps d'échantillonnage par une horloge synchronisée avec la fréquence desdits signaux modulés.

5. Dispositif pour mesurer avec précision les niveaux d'amplitude successifs d'un signal périodique d'amplitude variable, reçu sur une voie de transmission, comportant
- des moyens pour reconstituer un signal d'horloge synchrone avec ledit signal périodique;
- des moyens d'échantillonnage du signal périodique au moins pendant des intervalles de temps d'échantillonnage égaux chacun à une fraction définie de sa période et à une fréquence d'échantillonnage suffisante pour obtenir des groupes successifs contenant chacun un nombre défini d'échantillons distincts durant ledit intervalle de temps; et
- des moyens de numérisation sur un certain nombre n de bits de chacun des échantillons (E1...Em) contenu dans chaque groupe, caractérisé en ce qu'il comporte :
- des moyens de comparaison de chaque groupe d'échantillons numérisés avec une liste modèle préétablie de groupes d'échantillons admissibles pourvus de pondérations appropriées et, selon le résultat de chaque comparaison,
- des moyens (9, 10) incluant une unité de mémorisation pour affecter à chaque groupe d'échantillons numérisés, une valeur numérisée unique pondérée associée au groupe correspondant de la liste modèle et représentative du niveau effectif du signal périodique durant l'intervalle de temps d'échantillonnage, la pondération appliquée tenant compte de la fraction du signal qui est échantillonnée et, des conditions de propagation sur la voie de transmission.

6. Dispositif selon la revendication 5, caractérisé en ce que lesdits moyens de sélection comportent une mémoire (10) adressable contenant des mots numériques représentatifs de valeurs d'amplitude, et et des moyens (9) pour former des adresses de lecture de la mémoire à partir d'une partie au moins du contenu des moyens de mémorisation.

7. Dispositif selon la revendication 5, caractérisé en ce que lesdits moyens (9) pour former des adresses de lecture de la mémoire comportent des éléments de mémorisation pour l'ensemble des mots numériques prélevés durant chaque intervalle de temps d'échantillonnage.

8. Dispositif selon l'une des revendications 5 à 7, caractérisé en ce qu'il comporte des moyens (2) d'adaptation du niveau des signaux reçus sur ladite voie de transmission (1) avant leur application aux moyens de numérisation (8).

9. Dispositif selon l'une des revendications 5 à 8, caractérisé en ce que les moyens pour restituer un signal d'horloge comportent une horloge locale, des moyens de stockage (14, 15) connectés aux moyens de numérisation (8), pour des échantillons numérisés prélevés pendant des intervalles de temps (W') incluant des instants de transition dudit signal entre des niveaux d'amplitude, des moyens (16-18) pour déterminer les écarts relatifs de niveau les uns par rapport aux autres des échantillons prélevés durant chaque intervalle de temps et constituer avec chacun d'eux un ensemble de valeurs d'écart et un ensemble de commande pour générer des signaux de correction (CR0, CR1) en fonction de l'ensemble de valeurs d'écart obtenu, suite à la comparaison de chacun desdits ensembles avec une liste de configurations-types reconnues correctes, ces moyens de comparaison étant adaptés à produire des signaux de correction (CR0, CR1) permettant de resynchroniser l'horloge locale avec le signal d'horloge.

10. Dispositif selon la revendication 9, caractérisé en ce que lesdits moyens (16-18) pour déterminer les écarts relatifs, comportent deux registres (14, 15) adaptés à contenir les mots numériques successifs, des moyens (16) de comparaison deux à deux des mots numériques successifs contenus dans les deux registres (14, 15), et des moyens de mémorisation (17, 18) pour contenir les dits ensembles d'écarts relatifs.

11. Dispositif selon la revendication 9, caractérisé en ce que les moyens de comparaison (16) sont adaptés à comparer chaque écart relatif à un écart seuil.

12. Dispositif selon l'une des revendications 9 à 11, caractérisé en ce que l'horloge locale comporte un oscillateur à haute fréquence (11), des premiers moyens diviseurs de fréquence (12) pour diviser la fréquence du signal de l'oscillateur par plusieurs facteurs différents autour d'une valeur centrale, et sélectionner l'un des facteurs en fonction desdits signaux de correction (CR0, CR1) reçus des moyens de sélection, et des deuxièmes moyens diviseurs (13) connectés aux premiers moyens diviseurs (12) pour engendrer un premier signal à la même fréquence (f) que le signal d'horloge reçu et un signal de synchronisation à une fréquence (F) multiple de celle du premier signal.

## Patentansprüche

1. Verfahren zum Präzisionsmessen von aufeinanderfolgenden Amplitudenniveaus eines periodischen Signales von variabler Amplitude, das über einen Weg zur Übertragung erhalten wird, umfassend
- die Wiedergabe eines mit dem periodischen Signal synchronen Taktsignales H(f);
- die Abtastung des periodischen Signales wenigstens während Zeitintervalle (W) zur Abtastung, die jeweils zu einem definierten Teil von deren Periode und zu einer Abtastfrequenz (F), ausreichend, um aufeinanderfolgende Gruppen, welche jeweils eine definierte Anzahl von verschiedenen Abtastungen während des Zeitintervalles enthalten, gleich sind; und
- die Digitalisierung über eine bestimmte Anzahl n von Bits von jeder der Abtastungen (E1 ... Em), die in jeder Gruppe enthalten ist, wobei das Verfahren dadurch gekennzeichnet ist, daß es umfaßt:
- den Vergleich von jeder Gruppe von digitalisierten Abtastungen mit einer vorab gebildeten Musterliste aus zulässigen Gruppen von Abtastungen, welche mit geeigneten Gewichtungen versehen sind, und gemäß dem Ergebnis von jedem Vergleich;
- die Zuordnung eines zu dem tatsächlichen Niveau des periodischen Signales während des Zeitintervalles zur Abtastung repräsentativen, zu der Gruppe entsprechend der Modelliste zugeordneten, gewichteten, einzigen, digitalisierten Wertes zu jeder Gruppe von digitalisierten Abtastungen, wobei die angewendete Gewichtung dem Teil des Signales, welches abgetastet wird, und den Bedingungen zur Ausbreitung über den Übertragungsweg Rechnung trägt.

2. Verfahren nach Anspruch 1, dadurch gekennzeichnet, daß die Zuordnung bewirkt wird, indem ein zu dem Niveau des Signales während des Zeitintervalles zur Abtastung repräsentatives, einziges, digitalisiertes Wort direkt abgelesen wird, wenn die Konfiguration der Gruppe von digitalisierten Abtastungen einem digitalisierten Wort der vorab gebildeten Modelliste von digitalisierten Worten entspricht, wobei das digitalisierte Wort an einer Stelle eines Speichers lokalisiert wird, wobei die Adresse der Stelle durch die bei jeder Abtastung erhaltene Gruppe von digitalisierten Abtastungen festgelegt wird.

3. Verfahren nach Anspruch 1, dadurch gekennzeichnet, daß die erhaltenen Signale kodierte, digitalisierte Signale sind, deren Übertragung durch ein Taktsignal rhythmisiert werden, wobei es die Positionierung des Zeitintervalles zur Abtastung durch einen mit dem Taktsignal synchronisierten lokalen Taktgeber umfaßt.

4. Verfahren nach Anspruch 1, dadurch gekennzeichnet, daß die erhaltenen Signale in einer Amplitude modulierte Signale sind, wobei es die Positionierung des Zeitintervalles zur Abtastung durch einen mit der Frequenz der modulierten Signale synchronisierten Taktgeber umfaßt.

5. Vorrichtung zum Präzisionsmessen von aufeinanderfolgenden Amplitudenniveaus eines periodischen Signales von variabler Amplitude, das über einen Weg zur Übertragung erhalten ist, umfassend
- Einrichtungen zum Wiederherstellung eines mit dem periodischen Signal synchronen Taktsignales;
- Einrichtungen zur Abtastung des periodischen Signales wenigstens während Zeitintervalle zur Abtastung, die jeweils zu einem definierten Teil von deren Periode und zu einer Abtastfrequenz, ausreichend, um aufeinanderfolgende Gruppen, welche jeweils eine definierte Anzahl von verschiedenen Abtastungen während des Zeitintervalles enthalten, gleich sind; und
- Einrichtungen zur Digitalisierung über eine bestimmte Anzahl n von Bits von jeder der Abtastungen (E1 ... Em), die in jeder Gruppe enthalten ist, dadurch gekennzeichnet, daß sie umfaßt:
- Einrichtungen zum Vergleich von jeder Gruppe von digitalisierten Abtastungen mit einer vorab gebildeten Musterliste aus zulässigen Gruppen von Abtastungen, welche mit geeigneten Gewichtungen versehen sind, und gemäß dem Ergebnis von jedem Vergleich;
- Einrichtungen (9, 10), die eine Einheit zur Speicherung beinhalten, um einen zu dem tatsächlichen Niveau des periodischen Signales während des Zeitintervalles zur Abtastung repräsentativen, zu der Gruppe entsprechend der Modelliste zugeordneten, gewichteten, einzigen, digitalisierten Wert zu jeder Gruppe von digitalisierten Abtastungen zuzuordnen, wobei die angewendete Gewichtung dem Teil des Signales, welches abgetastet wird, und den Bedingungen zur Ausbreitung über den Übertragungsweg Rechnung trägt.

6. Vorrichtung nach Anspruch 5, dadurch gekennzeichnet, daß die Einrichtungen zur Auswahl einen adressierbaren Speicher (10), der zu den Amplitudenwerten repräsentative, digitalisierte Worte beinhaltet, und Einrichtungen (9) zum Bilden von Leseadressen des Speichers auf der Grundlage eines Teiles von wenigstens dem Inhalt der Einrichtungen zur Speicherung umfassen.

7. Vorrichtung nach Anspruch 5, dadurch gekennzeichnet, daß die Einrichtungen (9) zum Bilden von Leseadressen des Speichers Elemente zur Speicherung für die Gesamtheit von während jedes Zeitintervalles zur Abtastung entnommenen, digitalisierten Worten umfassen.

8. Vorrichtung nach einem der Ansprüche 5 bis 7, dadurch gekennzeichnet, daß sie Einrichtungen (2) zur Anpassung des Niveaus der erhaltenen Signale über den Übertragungsweg (1) vor deren Anlegung an Einrichtungen (8) zur Digitalisierung umfaßt.

9. Vorrichtung nach einem der Ansprüche 5 bis 8, dadurch gekennzeichnet, daß die Einrichtungen zum Wiederherstellen eines Taktsignales einen lokalen Taktgeber, mit den Einrichtungen (8) zur Digitalisierung verbundene Einrichtungen (14, 15) zur Aufbewahrung für die während der Zeitintervalle (W') entnommenen, digitalisierten Abtastungen, welche Übergangsmomente des Signales zwischen den Amplitudenniveaus enthalten, Einrichtungen (16 - 18) zum Bestimmen von relativen Niveauabständen der einen in bezug auf die anderen der während jedes Zeitintervalles entnommenen Abtastungen und Bilden einer Gesamtheit von Abstandswerten mit jedem von diesen, sowie eine Betätigungseinheit zum Erzeugen von Korrektursignalen (CR0, CR1) in Abhängigkeit der erhaltenen Gesamtheit von Abstandswerten nach dem Vergleich jeder der Gesamtheiten mit einer Liste von korrekten, gesichteten Konfigurationstypen, wobei diese Einrichtungen zum Vergleich geeignet sind, Korrektursignale (CR0, CR1) zu erzeugen, welche es gestatten, den lokalen Taktgeber mit dem Taktsignal zu synchronisieren, umfassen.

10. Vorrichtung nach Anspruch 9, dadurch gekennzeichnet, daß die Einrichtungen (16 - 18) zum Bestimmen der relativen Abstände zwei Register (14, 15), die geeignet sind, die aufeinanderfolgenden digitalisierten Worte zu enthalten, Einrichtungen (16) zum Vergleich von jeweils zwei der aufeinanderfolgenden digitalisierten Worten, die in den zwei Registern (14, 15) enthalten sind, und Einrichtungen (17, 18) zur Speicherung, um die Gesamtheiten relativer Abweichungen zu enthalten, umfassen.

11. Vorrichtung nach Anspruch 9, dadurch gekennzeichnet, daß die Einrichtungen (16) zum Vergleich geeignet sind, jede relative Abweichung mit einer Schwellenwertabweichung zu vergleichen.

12. Vorrichtung nach einem der Ansprüche 9 bis 11, dadurch gekennzeichnet, daß der lokale Taktgeber einen Hochfrequenzoszillator (11), erste Einrichtungen (12) zur Frequenzteilung, um die Frequenz des Oszillatorsignales durch mehrere unterschiedliche Faktoren um einen zentralen Wert herum zu teilen und den einen der Faktoren in Abhängigkeit der Korrektursignale (CR0, CR1), die von den Einrichtungen zur Auswahl empfangen sind, auszuwählen, sowie zweite Einrichtungen (13) zur Teilung, die mit den ersten Einrichtungen (12) zur Teilung verbunden sind, um ein erstes Signal mit der gleichen Frequenz (f) wie das empfangene Taktsignal und ein Synchronisationssignal mit einer Frequenz (F), die gleich dem Mehrfachen derjenigen des ersten Signales ist, zu erzeugen, umfaßt.

## Claims

1. A method for measuring accurately the successive amplitude levels of a periodic signal of variable amplitude, received on a transmission channel, consisting in:
- restoring a clock signal H(f) synchronised with the said periodic signal;
- sampling the periodic signal at least during sampling intervals (W) each of which is equal to a given fraction of its period and at a sampling frequency (F) which is sufficient to obtain successive groups each containing a given number of separate samples during the said period; and
- digitising a certain number n of bits of each of the samples (E1...Em) contained in each group, the method being characterised in that it consists in:
- comparing each group of digitised samples against a pre-determined master list of groups of permissible samples provided with appropriate weightings and, depending on the result of each comparison,
- assigning to each group of digitised samples a unique, weighted, digitised number associated with the corresponding group in the master list and representing the effective level of the periodic signal during the sampling period, where the weighting applied takes account of the fraction of the signal which is sampled and the propagation conditions on the transmission channel.

2. A method as claimed in claim 1, characterised in that the said assigning process is performed by directly reading off a unique digitised word representing the level of the signal during the sampling period if the configuration of the group of digitised samples corresponds to a digitised word in the said pre-determined master list of digitised words, the said digitised word being situated at a location in a memory, the address of the said location being fixed by the group of digitised samples obtained with each sampling.

3. A method as claimed in claim 1, characterised in that if the signals received are encoded digitised signals the transmission of which has been regulated by a clock signal, the sampling period is positioned by a local clock synchronised with the said clock signal.

4. A method as claimed in claim 1, characterised in that if the signals received are amplitude-modulated signals, the sampling period is positioned by a clock synchronised with the frequency of the said modulated signals.

5. A device for accurately measuring the successive amplitude levels of a periodic signal of variable amplitude, received on a transmission channel, comprising
- means for restoring a clock signal synchronised with the said periodic signal;
- means for sampling the periodic signal at least during sampling periods each of which is equal to a given fraction of its period and at a sampling frequency that will be sufficient to obtain successive groups each containing a given number of separate samples during the said period; and
- means for digitising over a certain number n of bits of each of the samples (E1...Em) contained in each group, characterised in that it comprises
- means for comparing each group of digitised samples with a pre-determined master list of groups of permissible samples provided with appropriate weightings and, depending on the result of each comparison,
- means (9, 10) having a memory unit which assigns to each group of digitised samples a unique, weighted, digitised value associated with the corresponding group in the master list and representing the effective level of the periodic signal during the sampling period, where the weighting applied takes account of the fraction of the signal which is sampled and the propagation conditions on the transmission channel.

6. A device as claimed in claim 5, characterised in that the said selecting means have an addressable memory (10) containing digital words representing amplitude values and means (9) for setting up read addresses in the memory on the basis of at least part of the content of the memory means.

7. A device as claimed in claim 5, characterised in that the said means (9) for setting up read addresses in the memory have memory elements for the set of digital words sampled during each sampling period.

8. A device as claimed in one of claims 5 to 7, characterised in that it has means (2) for adapting the level of the signals received on the transmission channel (1) before they are applied to the digitisation means (8).

9. A device as claimed in one of claims 5 to 8, characterised in that the means for restoring a clock signal have a local clock, storage means (14, 15) connected to digitising means (8) for digitised samples taken during the sampling period (W') including the instants of transition of the said signal between the amplitude levels, means (16-18) for determining the relative variations in level of the samples relative to one another taken during each period and setting up with each of them a set of variation values and a command set to generate correction signals (CR0, CR1) as a function of the set of variation values obtained after each of the said sets has been compared against a list of configuration types recognised as being correct, these comparing means being set up to generate correction signals (CR0, CR1) enabling the local clock to be re-synchronised with the clock signal.

10. A device as claimed in claim 9, characterised in that the said means (16-18) for determining the relative variations has two registers (14, 15) designed to contain successive digital words, means (16) for comparing in pairs successive digital words contained in the two registers (14, 15) and memory means (17, 18) to contain the said sets of relative variations.

11. A device as claimed in claim 9, characterised in that the comparing means (16) are set up to compare each relative variation against a threshold variation.

12. A device as claimed in one of claims 9 to 11, characterised in that the local clock has a highfrequency oscillator (11), first frequency-divider means (12) to divide the frequency of the oscillator signal by several different factors around a central value and to select one of these factors as a function of the said correction signals (CR0, CR1) received from the selection means, and second divider means (13) connected to the first divider means (12) to generate a first signal at the same frequency (f) as the clock signal received and a synchronisation signal at a frequency (F) which is a multiple of that of the first signal.
